# EUROPÄISCHE PATENTSCHRIFT

(11) **EP 0 382 868 B1**
(45) Veröffentlichungstag und Bekanntmachung des Hinweises auf die Patenterteilung: **27.01.1993**
(21) Anmeldenummer: 89102685.8
(22) Anmeldetag: 16.02.1989
(51) Int. Cl.: G01R 27/08

(54) **Schaltung zum Messen von Widerständen von Prüflingen**
Circuit for measuring the resistance of test objects
Circuit de mesure de résistance d'échantillons

(43) Veröffentlichungstag der Anmeldung: 22.08.1990
(73) Patentinhaber: MANIA GmbH & Co., D-61276 Weilrod (DE)
(72) Erfinder: Mang,Paul, D-6384 Schmitten 3 (DE); Driller,Hubert,Dipl.-Phys., D-6384 Schmitten 3 (DE)
(74) Vertreter: Ruschke, Hans Edvard, Dipl.-Ing.

(56) Entgegenhaltungen:
- DE-A- 3 615 550
- US-A- 3 974 443
- US-A- 4 706 015

## Beschreibung

Die Erfindung betrifft eine Schaltung zum Messen von Widerständen von Prüflingen nach dem Oberbegriff des Patentanspruches 1.

Bei der Messung von Widerständen, beispielsweise von Leiterbahnen oder Leiterbahnabschnitten auf Leiterplatten, treten Probleme auf, weil die zum Ansteuern der Leiterbahnen verwendeten Halbleiterschalter keine idealen Schalter sind. Genauer gesagt fließt im geöffneten Zustand eines solchen Halbleiterschalters ein Reststrom über einen Parallelwiderstand, während im geschlossenen Zustand des Halbleiters ein Spannungsabfall an einem Serienwiderstand zu verzeichnen ist. Dies bedeutet, daß im geschlossenen Zustand des Halbleiterschalters, d.h. also bei der elektrischen Verbindung mit einem Prüfling, Meßfehler auftreten, die auf den Spannungsabfall am Serienwiderstand zurückzuführen sind.

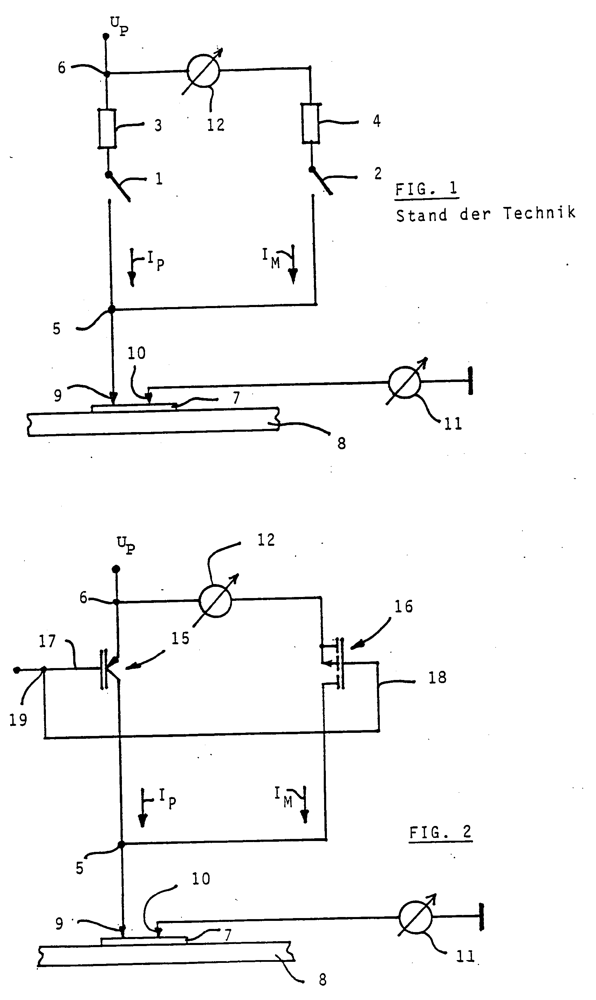

Aus diesem Grunde wird bei der Messung von Widerständen bekannterweise die sogenannte Kelvin-Methode angewendet, bei der gemäß Fig. 1 die Verbindung zum Prüfling über zwei Halbleiterschalter 1 und 2 hergestellt wird, die parallelgeschaltet sind und in der Fig. 1 durch Kontakte dargestellt sind. Dabei wird der Prüfstrom über den einen Schalter 1 und den Serienwiderstand 3 des Schalters 1 an den Prüfling 7 angelegt. Der an dem Serienwiderstand 3 des einen Schalters 1 auftretende Spannungsabfall wird durch die Spannungsmeßeinrichtung 12 gemessen, die dem anderen Schalter 2, der gleichzeitig mit dem einen Schalter 1 geschlossen wird, vorgeschaltet ist. Dadurch kann der Spannungsabfall am Serienwiderstand 3 einschließlich der Leitung bis zum Verbindungspunkt 5 gemessen und kompensiert werden. Im dargestellten Beispiel handelt es sich bei dem Prüfling 7 um einen Abschnitt einer Leiterbahn einer Leiterplatte 8, wobei dieser Abschnitt durch die schematisch dargestellten Prüfstifte 9 und 10 kontaktiert wird. Die den Strom I_{P} im Prüfkreis messende Meßeinrichtung ist mit 11 bezeichnet.

Die Aufgabe der vorliegenden Erfindung besteht darin, eine derartige Schaltung so auszugestalten, daß sie im Hinblick auf die zur Realisierung erforderliche Chipfläche und den im Prüfkreis anfallenden Leistungsverlust optimiert ist.

Diese Aufgabe wird durch eine Schaltung zum Messen von Widerständen von Prüflingen der eingangs genannten Art gelöst, die durch die in dem kennzeichnenden Teil des Patentanspruches 1 angegebenen Merkmale gekennzeichnet ist.

Der wesentliche Vorteil der Erfindung besteht darin, daß sich infolge der speziellen Auswahl eines Transistors vom IGBT-Typ (Insulated-Gate-Bipolar-Transistor) als Schalter für den Prüfkreis und eines Transistors vom MOS-Typ als Schalter für den Meßkreis die folgenden Eigenschaften erzielen lassen:
1) Im Prüfkreis ist ein äußerst geringer Leistungsverbrauch zu verzeichnen. Daraus resultiert, daß die Kristalltemperatur des Halbleitermaterials während der Durchschaltzeit des IGBT-Transistors nicht merklich erhöht wird, so daß sich keine temperaturabhängige Erhöhung des Reststromes ergibt, wenn der IGBT-Transistor gesperrt ist.
2) Im Meßkreis tritt bei dem fließenden, äußerst kleinen Meßstrom, der im µA-Bereich liegt, an dem vergleichsweise hohen Serienwiderstand 4 nur ein vernachlässigbarer Spannungsverlust auf, so daß keine Meßungenauigkeiten zu verzeichnen sind.
3) Das technologische Herstellungsverfahren ist relativ einfach, da sowohl der IGBT-Transistor als auch der MOS-Transistor mit ein und denselben Masken herstellbar sind.
4) Die relativ lange Schaltzeit des IGBT-Transistors ist in Kauf zu nehmen, weil sie bei der Anwendung von Schaltungen zum Messen und Prüfen im kHz-Bereich umproblematisch ist.

Weitere vorteilhafte Ausgestaltungen der Erfindung gehen aus den Unteransprüchen hervor.

Im folgenden werden die Erfindung und deren Ausgestaltungen im Zusammenhang mit den Figuren näher erläutert. Es zeigt:
Fig. 1 ein Schaltbild einer bekannten Schaltung zum Messen von Widerständen von Prüflingen;
Fig. 2 ein Schaltbild einer erfindungsgemäßen Schaltung zum Messen von Widerständen von Prüflingen; und
Fig. 3 bis 6 weitere Ausführungsformen der erfindungsgemäßen Schaltung.

In der Fig. 2 sind Elemente, die bereits im Zusammenhang mit der Fig. 1 erläutert wurden, durch entsprechende Bezugszeichen bezeichnet. In der ersichtlichen Weise ist im Prüfkreis der Halbleiterschalter 1 der Fig. 1 durch einen Transistor 15 vom IGBT-Typ (Insulated-Gate-Bipolar-Transistor) ersetzt, der über seinen Steueranschluß 17 ansteuerbar ist. Entsprechend ist im Meßkreis der Halbleiterschalter 2 der Fig. 1 durch einen MOS-Transistor 16 ersetzt, der über seinen Steueranschluß 18 ansteuerbar ist. Dabei sind die Steueranschlüsse 17 und 18 vorzugsweise in einem Verknüpfungspunkt 19 zusammengelegt, so daß der IBGT-Transistor 15 und der MOS-Transistor 16 zusammen ansteuerbar bzw. taktbar sind.

Zur Prüfung des Widerstandes der Leiterbahn 7 zwischen den Prüfspitzen 9 und 10 wird wie folgt vorgegangen.

An den Verknüpfungspunkt 19 wird ein Einschaltpotential angelegt, so daß die Transistoren 15 und 16 gleichzeitig durchgeschaltet werden. Der über den leitenden IBGT-Transistor 15 und den Leiterbahnabschnitt zwischen den Prüfspitzen 9 und 10 fließende Prüfstrom I_{P} wird durch die Strommeßeinrichtung 11 ermittelt. Gleichzeitig wird durch die Spannungsmeßeinrichtung 12 des Meßkreises der Spannungsabfall am IBGT-Transistor 15 und an dem Leitungsabschnitt zwischen dem IGBT-Transistor 15 und dem Verbindungspunkt 5 ermittelt. Entsprechend diesem Spannungsabfall wird das an der Strommeßeinrichtung 11 gemessene Meßergebnis korrigiert, so daß mit dem korrigierten Meßwert eine genaue Aussage über den Widerstand zwischen den Prüfspitzen 9 und 10 möglich ist. Dabei ist es von Bedeutung, daß der den Prüfstrom I_{P} führende IGBT-Transistor 15, der als Leistungssteller dient, einen verhältnismäßig geringen Leistungsverlust hat. Daher wird dieser IGBT-Transistor 15 beim Durchschalten auch verhältnismäßig wenig erwärmt, was im Hinblick auf die Vermeidung eines temperaturabhängigen Reststromes nach der Durchschaltzeit im gesperrten Zustand des Transistors 15 von Bedeutung ist. Dabei spielt es keine Rolle, daß der IGBT-Transistor eine vergleichsweise schlechte Linearität besitzt, weil ohnehin eine Nachmessung des tatsächlichen Spannungsabfalles am IGBT-Transistor 15 durch den den MOS-Transistor 16 aufweisenden Meßkreis erfolgt. Dieser MOS-Transistor 16 besitzt nämlich eine ausgezeichnete Linearität. Da im Meßkreis ohnehin kein großer Meßstrom I_{M} fließen soll, spielt es auch keine Rolle, da ein Transistor vom MOS-Typ nicht für relativ große Ströme geeignet ist. Es ist lediglich von Bedeutung, daß der MOS-Transistor 16 den Spannungsabfall am Transistor 15 sehr genau messen kann.

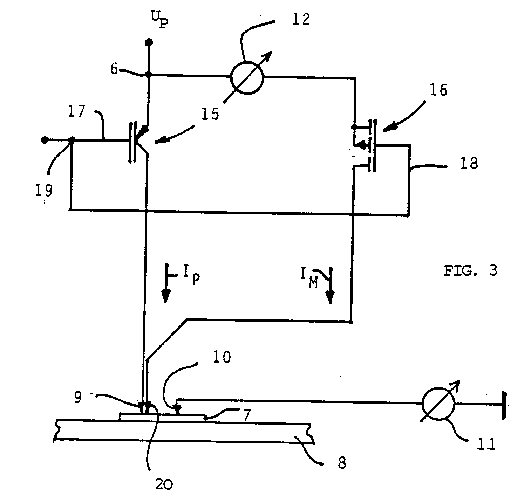

Während mit der Schaltung der Fig. 2 eine Messung des Spannungsabfalls im Prüfkreis nur bis zum Verknüpfungspunkt 5 möglich ist, kann bei der Schaltung der Fig. 3 eine Messung des Spannungsabfalles tatsächlich bis zur Prüfspitze 9 erfolgen, so daß eine äußerst genaue Kompensation des Spannungsabfalles im Prüfkreis möglich ist. Einzelheiten der Fig. 3, die bereits im Zusammenhang mit den Fig. 1 und 2 beschrieben wurden, sind in der entsprechenden Weise bezeichnet. In der ersichtlichen Weise ist der in der Fig. 2 zum Verbindungspunkt 5 führende Anschluß des MOS-Transistors 16 mit einer weiteren Prüfspitze 20 verbunden, die an der Leiterbahn 7 ganz in der Nähe der Prüfspitze 9 einen Kontakt herstellt. Auf diese Weise wird erreicht, daß der Meßkreis den Spannungsabfall am IGBT-Transistor 15 und auch an der gesamten Verbindung vom IGBT-Transistor 15 bis hin zur Prüfspitze 9 erfaßt. Bei der Anordnung der Fig. 3 kann daher eine noch genauere Kompensation des Spannungsabfalles im Prüfkreis erfolgen.

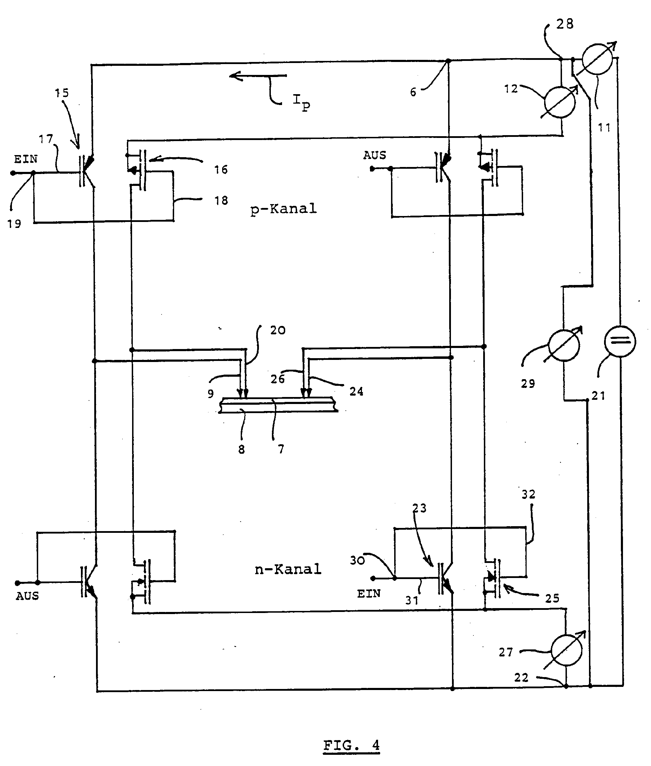

Im Zusammenhang mit der Fig. 4 wird nun eine bevorzugte Schaltung zum Messen von Widerständen von Prüflingen beschrieben, mit deren Hilfe sämtliche Spannungsabfälle im gesamten Prüfkreis, d.h. also auf beiden Seiten des Prüflings 7, kompensierbar sind. Einzelheiten der Fig. 4, die bereits im Zusammenhang mit den anderen Figuren erläutert wurden, sind in der entsprechenden Weise bezeichnet.

In der im Zusammenhang mit der Fig. 3 bereits beschriebenen Weise ist die eine Seite, das ist in der Fig. 4 die linke Seite, des Prüflings 7 mit den Prüfspitzen 9 und 20 kontaktiert. Der Prüfstrom I_{P}, der von der Stromquelle 21 eingeprägt wird, fließt zwischen den Punkten 6 und 22. Der Verbindungspunkt 6 ist über den IGBT-Transistor 15 mit der Prüfspitze 9 verbunden, während der Verbindungspunkt 6 über den MOS-Transistor 16 mit der Prüfspitze 20 in Verbindung steht. Die Transistoren 15 und 16 sind gemeinsam durch Anlegen einer Steuerspannung an den Verbindungspunkt 19 ein- und ausschaltbar. Die Spannungsmeßeinrichtung 12 zeigt den Spannungsabfall zwischen dem Punkt 6 und der Prüfspitze 9 sehr genau an, da die Prüfspitzen 9 und 20 eng aneinander liegen.

Für die rechte Seite des Prüflings 7 sind ein weiterer Prüfkreis und ein weiterer Meßkreis vorgesehen. Der weitere Prüfkreis weist einen IGBT-Transistor 23 auf, der eine am Prüfling 7 anliegende Prüfspitze 24 mit dem Verbindungspunkt 22 verbindet. Der weitere Meßkreis weist den MOS-Transistor 25 auf, der die nahe an der Prüfspitze 24 den Prüfling 7 kontaktierende Prüfspitze 26 über die Spannungsmeßeinrichtung 27 mit dem Verbindungspunkt 22 elektrisch verbindet. Die Steueranschlüsse 31 und 32 der Transistoren 23 und 25 sind in dem Verbindungspunkt 30 zusammengeführt und durch Anlegen einer Steuerspannung an dem Verbindungspunkt 30 gemeinsam ein- und ausschaltbar.

Der zum IGBT-Transistor 15 führende Ausgang 28 der Strommeßeinrichtung 11 ist über eine weitere Spannungsmeßeinrichtung 29 mit dem zur Strommeßeinrichtung 21 führenden Ausgang 22 der Spannungsmeßeinrichtung 27 verbunden. Wenn bei der so weit beschriebenen Schaltung die Transistoren 15, 16, 23 und 25 gleichzeitig durch gleichzeitiges Anlegen eines Steuerspannung an die Verbindungspunkte 19 und 30 eingeschaltet werden, fließt ein von der Strommeßeinrichtung 11 gemessener Prüfstrom I_{P} zwischen den Verbindungspunkten 6 und 22 über den IGBT-Transistor 15, die Prüfspitze 9, den Prüfling 7, die Prüfspitze 24 und den IGBT-Transistor 23. Es zeigt daher die Spannungsmeßeinrichtung 12 den Spannungsabfall zwischen dem Verbindungspunkt 6 und der Prüfspitze 9 an. Die Spannungsmeßeinrichtung 27 zeigt den Spannungsabfall zwischen der Prüfspitze 24 und dem Verbindungspunkt 22 an. Die Spannungsmeßeinrichtung 29 ermittelt die Differenzspannung zwischen der Summe der beiden zuvor genannten Spannungsabfälle und der durch die Quelle 21 an den Punkten 22 und 28 aufgebauten Spannung. Diese Differenzspannung entspricht daher dem Spannungsabfall am Prüfling 7. Dies bedeutet, daß bei der Prüfung nur dieser Spannungsabfall für die Bewertung berücksichtigt werden muß. Genauer gesagt entspricht der Widerstand des Prüflings 7 dem Produkt aus dem Prüfstrom I_{P}, der an der Strommeßeinrichtung 11 angezeigt wird, und der an der Spannungsmeßeinrichtung 29 angezeigten Spannung.

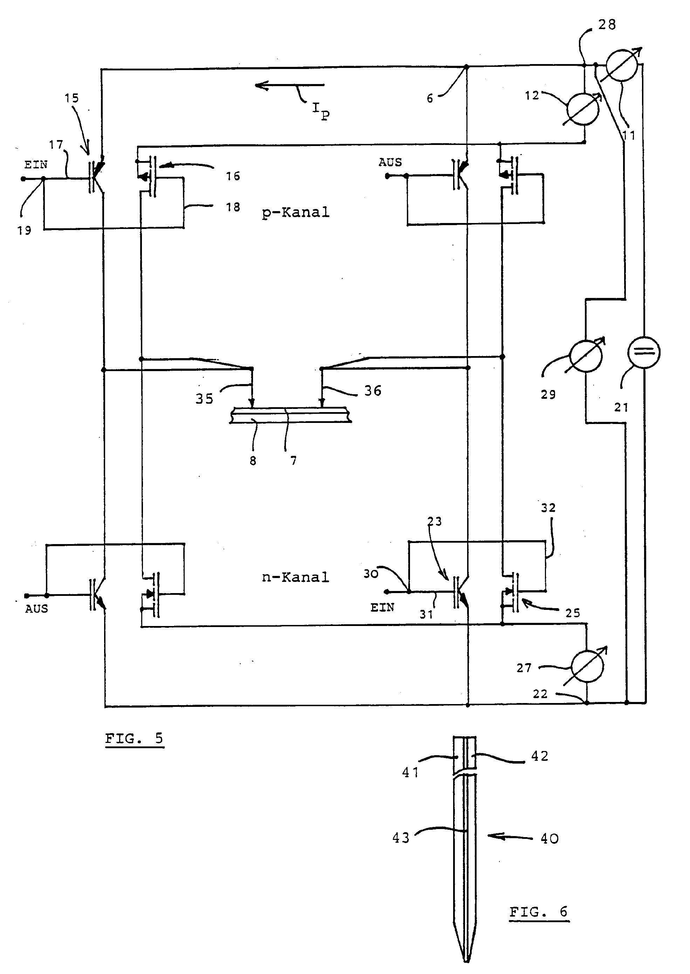

Aus der Fig. 5 geht eine Weiterbildung hervor, die, von der Tatsache abgesehen, daß eine Kontaktierung des Prüflings 7 an jeder Seite lediglich über eine einzige Prüfspitze erfolgt, der Schaltung der Fig. 4 entspricht. Auf der linken Seite des Prüflings 7 stellt eine Prüfspitze 35 eine elektrische Verbindung zwischen dem Prüfling 7 und dem IGBT-Transistor 15 sowie dem MOS-Transister 16 her. Auf der rechten Seite des Prüflings 7 stellt eine Prüfspitze 36 eine elektrische Verbindung zwischen dem Prüfling 7 und dem IGBT-Transistor 25 her. Die Messung erfolgt in der im Zusammenhang mit der Fig. 4 beschriebenen Weise, wobei lediglich der Spannungsabfall an den Prüfspitzen 35 und 36 nicht erfaßbar und berücksichtigbar ist. Diese Schaltung ist aber sehr viel einfacher aufgebaut, da insgesamt an der Stelle von vier Prüfspitzen nur die beiden Prüfspitzen 35 und 36 vorgesehen werden müssen. Dies führt zu einer erheblichen Kosten- und Platzeinsparung, so daß die geringfügig kleinere Meßgenauigkeit in Kauf zu nehmen ist.

In den Fig. 4 und 5 sind neben den Transistorpaaren 15, 16 und 23, 25 weitere Transistorpaare dargestellt, die bei der beschriebenen Meßoperation ausgeschaltet sind. Diese Transistorpaare werden im Verlauf der Prüfung des Widerstandes benachbarter Prüflingsabschnitte, beispielsweise benachbarter Leiterbahnabschnitte, wahlweise zugeschaltet, wobei dann die Transistorpaare 15, 16 und 23, 25 gesperrt werden. Beispielsweise wird das nicht näher bezeichnete, links unten dargestellte Transistorpaar bei der Prüfung eines links an die Prüfspitzen 9, 20 bzw. an die Prüfspitze 35 angrenzenden weiteren Leiterbahnabschnittes zusammen mit einem nicht dargestellten Transistorpaar angewendet, das den Prüfspitzen bzw. der Prüfspitze zugeordnet ist, die den weiteren Leiterbahnabschnitt an der den Prüfspitzen 9, 20 bzw. der Prüfspitze 35 abgewandten Seite begrenzt. Die Messung selbst erfolgt in derselben Weise wie die beschriebene Messung des Widerstandes des Leiterbahnabschnittes zwischen den Prüfspitzen 9, 20 und 24, 26 bzw. den Prüfspitzen 35 und 36.

An der Stelle der genannten Prüfspitzen können zweckmäßigerweise an sich bekannte Prüfstifte zur Kontaktierung verwendet werden. Im Falle der Ausführungsformen der Fig. 3 und 4 ist es denkbar, jeweils einen Prüfstift des Prüfkreises und einen Prüfstift des Meßkreises zu einer Prüfstifteinheit zusammenzufassen. Beispielsweise können die Prüfstifte 9 und 20 und die Prüfstifte 24 und 26 zu einer solchen Prüfstifteinheit zusammengefaßt werden. Dadurch kann die die Prüfstifte enthaltende Adaptiervorrichtung, die eine Verbindung zwischen einer Leiterplatte und einem Rasterkontaktfeld herstellt, einfacher aufgebaut sowie einfacher und schneller bestückt werden. Beispielsweise kann entsprechend der Fig. 6 eine solche Prüfstifteinheit 40 dadurch hergestellt werden, daß zwei Prüfstiftteile 41, 42 voneinander elektrisch isoliert zusammengesetzt werden. In der Fig. 6 ist die entsprechende Isolierschicht mit 43 bezeichnet.

Aus Gründen der Antisymmetrie der Ansteuerung sind die verwendeten Transistortypen der oberen Zweige und der unteren Zweige der Schaltungen der Figuren 4 und 5 vorzugsweise komplementär. Entsprechend werden die p-Kanal-Transistoren der oberen Zweige durch eine negative Spannung und die n-Kanal-Transistoren der unteren Zweige durch eine positive Spannung eingeschaltet.

## Patentansprüche

1. Schaltung zum Messen von Widerständen von Prüflingen, mit einem einen ersten elektronischen Halbleiterschalter (1,15) aufweisenden Prüfkreis, der ferner einen Prüfling (7) und eine den über den Prüfling (7) fließenden Prüfstrom (I_{P}) messende Strommeßeinrichtung (11) umfaßt, und mit einem einen zweiten elektronischen Halbleiterschalter (2,16) aufweisenden Meßkreis, der parallel zum ersten elektronischen Halbleiterschalter (15) geschaltet ist und eine einen Spannungsabfall am Prüfkreis messende Spannungseinrichtung (12) umfaßt, dadurch gekennzeichnet, daß der erste Halbleiterschalter ein Transistor (15) vom IGBT-Typ ist und daß der zweite Halbleiterschalter ein Feldeffekttransistor ist.

2. Schaltung nach Anspruch 1, dadurch gekennzeichnet, daß der erste und zweite Halbleiterschalter (15, 16) durch gemeinsame Ansteuerung ein- und ausschaltbar sind.

3. Schaltung nach Anspruch 1 oder 2, dadurch gekennzeichnet, daß der Feldeffekttransistor ein Transistor (16) vom MOS-Typ ist.

4. Schaltung nach einem der Ansprüche 1 bis 3, dadurch gekennzeichnet, daß der Meßkreis parallel zu dem Transistor (15) vom IGBT-Typ und im wesentlichen dem gesamten Prüfkreisabschnitt zwischen dem Transistor (15) vom IGBT-Typ und dem Prüfling (7) geschaltet ist.

5. Schaltung nach Anspruch 4, dadurch gekennzeichnet, daß der Prüfling (7) durch Prüfspitzen (35, 36) des Prüfkreises kontaktiert ist und daß der Prüfkreisabschnitt bis zu dem dem kontaktierenden Prüfling (7) abgewandten Ende einer Prüfspitze (35) reicht.

6. Schaltung nach einem der Ansprüche 1 bis 3, dadurch gekennzeichnet, daß der Prüfling (7) durch Prüfspitzen (9, 10) des Prüfkreises kontaktiert ist und daß der Meßkreis eine weitere Prüfspitze (20) aufweist, die in der Nähe einer der Prüfspitzen (9) des Prüfkreises angeordnet ist, so daß der Meßkreis parallel zu dem Transistor (15) vom IGBT-Typ und dem gesamten Prüfkreisabschnitt zwischen dem Transistor (15) vom IGBT-Typ und der Kontaktspitze einer dem Prüfling (7) kontaktierenden Prüfspitze (9) geschaltet ist.

7. Schaltung nach Anspruch 5 oder 6, dadurch gekennzeichnet, daß als Prüfspitzen (9, 10) des Prüfkreises Prüfstifte vorgesehen sind.

8. Schaltung nach einem der Ansprüche 5 bis 7, dadurch gekennzeichnet, daß als weitere Prüfspitze des Meßkreises ein Prüfstift (20) vorgesehen ist.

9. Schaltung nach Anspruch 8, dadurch gekennzeichnet, daß der eine Prüfstift des Prüfkreises und der weitere Prüfstift des Meßkreises dadurch gebildet sind, daß zwei elektrisch leitende Prüfstiftteile (41, 42) voneinander elektrisch isoliert zu einer Prüfstifteinheit (40) zusammengesetzt sind.

10. Schaltung nach einem der Ansprüche 1 bis 9, dadurch gekennzeichnet, daß ein dem Prüfkreis entsprechender weiterer Prüfkreis (23, 24, 23, 36) vorgesehen ist, der auf der anderen Seite des Prüflings (7) wie der Prüfkreis so angeordnet ist, daß der Prüfstrom (I_{P}) durch den Prüfkreis und den weiteren Prüfkreis fließt, daß dem Prüfkreis und dem weiteren Prüfkreis die Strommeßeinrichtung (11) gemeinsam ist, und daß dem weiteren Prüfkreis ein dem Meßkreis entsprechender weiterer Meßkreis (25, 26; 25, 36) mit einer weiteren Spannungsmeßeinrichtung (27) zugeordnet ist.

## Claims

1. Circuitry for measuring resistances of test samples, with a test circuit comprising a first electronic semiconductor switch (1, 15) and additionally comprising a test sample (7) and a current measuring apparatus (11) measuring the test current (Iₚ) flowing over the test sample (7), and with a measuring circuit comprising a second electronic semiconductor switch (2, 16), which measuring circuit is connected in parallel with the first electronic semiconductor switch (15) and comprises a voltage apparatus (12) measuring a voltage drop at the test circuit, characterized in that the first semiconductor switch is a transistor (15) of the IGBT type and in that the second semiconductor switch is a field effect transistor.

2. Circuitry according to claim 1, characterized in that the first and second semiconductor switches (15, 16) can be switched on and off by joint drive.

3. Circuitry according to claim 1 or claim 2, characterized in that the field effect transistor is an MOS type transistor (16).

4. Circuitry according to any one of claims 1 to 3, characterized in that the measuring circuit is connected in parallel with the transistor (15) of the IGBT type and substantially with the entire test circuit section between the transistor (15) of the IGBT type and the test sample (7).

5. Circuitry according to claim 4, characterized in that the test sample (7) is contacted by test prods (35, 36) of the test circuit and in that the test circuit section extends as far as the end of a test prod (35) remote from the contacting test sample (7).

6. Circuitry according to any one of claims 1 to 3, characterized in that the test sample (7) is contacted by test prods (9, 10) of the test circuit and in that the measuring circuit comprises a further test prod (20), which is arranged in the vicinity of one of the test prods (9) of the test circuit, such that the measuring circuit is connected in parallel with the transistor (15) of the IGBT type and the entire test circuit section between the transistor (15) of the IGBT type and the contact tip of a test prod (9) contacting the test sample (7).

7. Circuitry according to claim 5 or claim 6, characterized in that test pins are provided as test prods (9, 10) of the test circuit.

8. Circuitry according to any one of claims 5 to 7, characterized in that a test pin (20) is provided as additional test prod of the measuring circuit.

9. Circuitry according to claim 8, characterized in that one of the test pins of the test circuit and the additional test pin of the measuring circuit are formed by assembling two electrically conductive test pin parts (41, 42) insulated electrically from each other into a test pin unit (40).

10. Circuitry according to any one of claims 1 to 9, characterized in that a further test circuit (23, 24, 23, 36) corresponding to the test circuit is provided which is arranged on the other side of the test sample (7) from the test circuit in such a way that the test current (Iₚ) flows through the test circuit and the further test circuit, in that the current measuring apparatus (11) is common to the test circuit and the further test circuit and in that a further measuring circuit (25, 26; 25, 36) corresponding to the measuring circuit and having a further current measuring apparatus (27) is associated with the test circuit.

## Revendications

1. Circuit pour la mesure de résistances d'échantillons, comportant un circuit de test, qui présente un premier commutateur électronique à semi-conducteur (1, 15) et qui comprend en outre un échantillon (7) et un dispositif de mesure de courant mesurant le courant de test (Iₚ) s'écoulant au travers de l'échantillon (7), et comportant un circuit de mesure qui présente un second commutateur électronique à semi-conducteur (2, 16), qui est branché en parallèle au premier commutateur électronique à semi-conducteur (15) et qui comprend un dispositif de tension (12) mesurant une chute de tension du circuit de test, caractérisé en ce que le premier commutateur à semi-conducteur est un transistor (15) du type IGBT et en ce que le second commutateur à semi-conducteur est un transistor à effet de champ.

2. Circuit suivant la revendication 1, caractérisé en ce que les premier et second commutateurs à semi-conducteur (15, 16) peuvent être enclenchés et mis hors service par une commande commune.

3. Circuit suivant la revendication 1 ou 2, caractérisé en ce que le transistor à effet de champ est un transistor (16) du type MOS.

4. Circuit suivant l'une des revendications 1 à 3, caractérisé en ce que le circuit de mesure est branché en parallèle au transistor (15) du type IGBT et essentiellement à la section totale du circuit de test, entre le transistor (15) du type IGBT et l'échantillon (7).

5. Circuit suivant la revendication 4, caractérisé en ce que l'échantillon (7) est mis en contact par des pointes de test (35, 36) du circuit de test et en ce que la section de circuit de test parvient jusqu'à l'extrémité, d'une pointe de test (35), tournée à l'écart de l'échantillon (7) à mettre en contact.

6. Circuit suivant l'une des revendications 1 à 3, caractérisé en ce que l'échantillon (7) est mise en contact par des pointes de test (9, 10) du circuit de test et en ce que le circuit de mesure présente une autre pointe de test (20) qui est agencée à proximité d'une des pointes de test (9) du circuit de test, de sorte que le circuit de mesure soit branché en parallèle au transistor (15) du type IGBT et à la section totale de circuit de test, entre le transistor (15) du type IGBT et la pointe de contact d'une pointe de test (9) mise en contact avec l'échantillon (7).

7. Circuit suivant la revendication 5 ou 6, caractérisé en ce que des broches de test sont prévues en tant que pointes de test (9, 10) du circuit de test.

8. Circuit suivant l'une des revendications 5 à 7, caractérisé en ce qu'une broche de test (20) est prévue en tant qu'autre pointe de test du circuit de mesure.

9. Circuit suivant la revendication 8, caractérisé en ce qu'une des broches de test du circuit de test et l'autre broche de test du circuit de mesure sont formées par le fait que deux éléments de broche de test (41, 42) électriquement conducteurs sont réunis, de façon électriquement isolée l'un par rapport à l'autre, en un ensemble de broche de test (40).

10. Circuit suivant l'une des revendications 1 à 9, caractérisé en ce qu'est prévu un autre circuit de test (23, 24; 23, 36) qui correspond au circuit de test et qui est agencé de l'autre côté de l'échantillon (7) que le circuit de test de façon que le courant de test (Iₚ) s'écoule au travers du circuit de test et de l'autre circuit de test, en ce que le dispositif de mesure de courant (11) est commun au circuit de test et à l'autre circuit de test et en ce qu'à l'autre circuit de test est adjoint un autre circuit de mesure (25, 26; 35, 36), correspondant au circuit de mesure, avec un autre dispositif de mesure de tension (27).
